**Europäisches Patentamt**

**European Patent Office**

**Office européen des brevets**

(19)

(11) Numéro de publication: **0 165 829**
**B1**

# (12) FASCICULE DE BREVET EUROPÉEN

(45) Date de publication du fascicule du brevet:
08.03.89

(21) Numéro de dépôt: **85400844.8**

(22) Date de dépôt: **29.04.85**

(51) Int. Cl.⁴: **H 01 L 23/46,** H 01 L 23/04

(54) **Boîtier à dissipation thermique d'encapsulation de circuits électriques.**

(30) Priorité: **11.05.84 FR 8407297**

(43) Date de publication de la demande:
**27.12.85 Bulletin 85/52**

(45) Mention de la délivrance du brevet:
**08.03.89 Bulletin 89/10**

(84) Etats contractants désignés:
**AT DE GB IT**

(56) Documents cité:
**EP-A-0 094 869**
**FR-A-2 436 498**
**FR-A-2 500 215**

(73) Titulaire: **XERAM, Tour Manhattan 6, place de
l'Iris La Défense, F-92400 Courbevoie (FR)**

(72) Inventeur: **Taverdet, Jean-Claude, THOMPSON-
CSF SCPI 173, bld Haussmann, F-75379 Paris
Cedex 08 (FR)**

(74) Mandataire: **Séraphin, Léon, PECHINEY 28, rue de
Bonnel, F-69433 Lyon Cedex 3 (FR)**

LIBER, STOCKHOLM 1989

## Description

La présente invention a pour objet un boîtier à dissipation thermique d'encapsulation de circuits électriques.

On sait que l'évolution actuelle des circuits intégrés et des circuits hybrides conduit à des dissipations thermiques par unité de surface qui ne cessent de croître.

L'évacuation des calories ainsi produites doit se faire par l'intermédiaire du boîtier sur lequel le ou les circuits sont montés.

Ainsi, lorsque les jonctions d'un dispositif semi-conducteur en fonctionnement sont portées à une température nettement supérieure à la valeur maximale recommandée, il se produit une modification de leur état de surface qui entraîne des détériorations irréversibles, cumulatives, des caractéristiques du dispositif. Pour certains composants au silicium, la température maximale de jonction est d'environ 200°C, mais une limite plus basse est souvent nécessaire particulièrement dans le cas des dispositifs encapsulés dans une matière plastique. La fiabilité est, en général, améliorée par un fonctionnement à des températures nettement inférieures à la valeur maximale recommandée.

Il est donc essentiel que le boîtier assure une résistance thermique optimale pour que celui-ci soit susceptible d'assurer l'évacuation d'un nombre élevé de calories par unité de surface de substrat (à titre d'exemple, des résistances thermiques aussi faibles que 1°C/W sont souhaitables).

Les circuits intégrés sont souvent montés en modules qui ont un capot métallique. Le transfert de chaleur implique un transfert du circuit intégré vers son module puis de ce module vers un dissipateur externe. Quand la quantité de chaleur, qui doit être dissipée, est relativement faible, le capot métallique du module peut être exposé à l'air et le fond du module relié au circuit imprimé par l'intermédiaire de broches. La chaleur du circuit intégré est ainsi dissipée à la fois à travers le substrat du circuit sur lequel le module est monté et à travers le capot metallique de ce module.

Dans certaines applications, la quantité de chaleur dissipée de cette manière n'est pas suffisante.

Il existe différents dispositifs qui permettent d'augmenter la quantité de chaleur du circuit intégré qui peut être dissipée.

On connaît ainsi des boîtiers hermétiques couramment disponibles et qui sont constitués d'un corps ou cuvette en alliage Fer-Nickel-Cobalt sur lequel sont scellées avec un verre borosilicate des traversées également en alliage Fer-Nickel-Cobalt. Un substrat est collé ou brasé sur le fond du boîtier qui, du fait qu'il est en alliage Fer-Nickel-Cobalt, est un mauvais dissipateur thermique.

Ainsi, l'article du "IBM TECHNICAL DISCLOSURE BULLETIN", vol. 19, N°8, pages 2976 - 2977, New York, US de Janvier 1977 intitulé "Multimode heat sink" décrit un dispositif qui comporte un dissipateur de chaleur muni de réceptacles. Les modules, qui sont montés sur un circuit imprimé, sont disposés à l'intérieur de ces réceptacles. Une soudure à faible température de fusion assure la connexion entre les modules et le fond de ces réceptacles. Ce dissipateur peut inclure un circuit de circulation d eau qui permet de transférer la chaleur vers l'extérieur.

On connaît aussi la demande de brevet EP-94 869 qui décrit un boîtier d'encapsulation formé d'un cadre métallique portant des connexions d'accès fixées par perles de verre, et soudé à un fond métallique bon conducteur de la chaleur par brasure à haute temperature; pour ce type de boîtier, quand il renferme un élément de puissance, le fond métallique permet de dissiper la chaleur de fonctionnement.

Mais ces dispositifs ne sont pas modulaires et au contraire, le boîtier selon l'invention permet de réaliser un réseau de circulation de fluide caloporteur qui permet un refroidissement au plus près des pieces et permet ainsi d'éviter un réchauffement des pièces restées froides.

L'invention a pour objet un boîtier métallique d'encapsulation de circuits électriques à dissipation thermique élevée, comportant une armature métallique monobloc limitée par des faces latérales, ladite armature comprenant une partie supérieure comportant une cavité dont le fond est destiné à la fixation de ces circuits électriques, et dont les parois latérales supportent des connexions par l'intermédiaire de traversées isolantes, un couvercle étant disposé à la surface de cette cavité de manière à rendre celle-ci hermétique, ladite armature comprenant en outre une partie inférieure contenant des moyens de refroidissement, pour circulation d'au moins un fluide caloporteur, les moyens de refroidissement étant constitués par un réseau modulaire de circulation du fluide caloporteur de manière à effectuer un refroidissement au plus près des pièces chaudes sans échauffement des pièces restées froides, ledit réseau étant obtenu au moyen d'alésages percés entre deux faces latérales parallèles, régulièrement espacés, séparés les uns des autres par des cloisons parallèles, deux alésages voisins communiquant entre eux à l'aide d'ajours percés dans une des ou les deux extrémités de la cloison commune, deux éléments métalliques étant disposés sur les faces latérales de cette armature monobloc de manière à obturer les extrémités de ces alésages et les ajours, ces moyens de refroidissement comportant au moins deux orifices de manière à permettre l'entrée et la sortie du fluide caloporteur.

L'invention sera mieux comprise à la lecture de la description qui va suivre donnée à titre d'exemple non limitatif, en relation avec les dessins annexés qui représentent:

- la figure 1, un dispositif de l'art antérieur;
- la figure 2, le boîtier selon l'invention;
- les figures 3 et 4, deux vues explicatives du boîtier selon l'invention;
- les figures 5 et 6, deux vues en coupe du boîtier selon l'invention;
- la figure 7, une vue latérale du boîtier selon l'invention;
- la figure 8, une vue de dessus du boîtier selon l'invention.

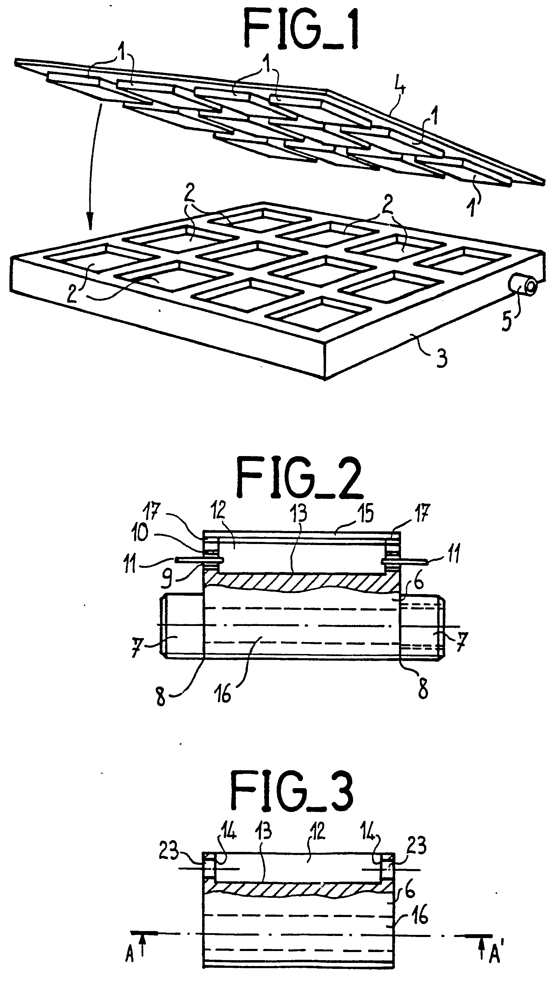

La figure 1 illustre un dispositif de l'art antérieur décrit dans 1 "IBM TECHNICAL DISCLOSURE BULLETIN", vol. 19, N° 8, pages 2976 - 2977, New York, US de Janvier 1977 intitulé "Multimode heat sink" dans lequel des modules 1 sont montés sur un substrat 4 de façon conventionnelle. Le dessus des modules 1, par contre, est placé dans des réceptacles 2 sur le dissipateur de chaleur 3. Cette structure non assemblée est illustrée à la figure 1. Une soudure à faible température de fusion, qui peut être du type ayant un rétreint négatif après solidification, entoure chacun des modules et réalise une connexion étroite entre les modules et le dissipateur de chaleur 3. Ce dissipateur de chaleur 3 peut inclure un passage 5 pour la circulation d' eau qui permet de transporter la chaleur vers l'extérieur. Cette structure est assemblée en faisant fondre la soudure et en plaçant le substrat avec les modules 1 dans les réceptacles 2 du dissipateur de chaleur 3.

L'invention, quant à elle, concerne un boîtier d'encapsulation pour circuit électrique ou est intégré son système de refroidisse ment par circulation de fluide caloporteur. Comme représenté à la figure 2, ce boîtier comporte une armature métallique 6 supportant les fils de connexion du circuit électrique et au moins un couvercle 15 soudé sur l'armature, un ou plusieurs systèmes de refroidissement par fluide caloporteur avec son réseau de circulation 16.

L'invention est plus particulièrement employée pour la réalisation de boîtier d'encapsulation de grande puissance utilisant des composants à forte dissipation thermique.

L'armature 6 du boîtier comprend plusieurs parties une cavite 12 permettant le positionnement des composants, soit par fixation mécanique ou par brasage tendre ou par circuit pré-cablé collé sur le fond 13 de la cavité 12, sur les parois latérales du boîtier les fils de connexion sont des broches 11 de géométrie diverse scellées par liaison verre métal et implantees sur l'armature par brasure, et souvent espacées de 2,54 mm ou 5,08 mm suivant les normes de cablage de l'électronique.

Ainsi, les connexions se présentent sous la forme de broches 11 dont chacune est maintenue en position par une traversée isolante 9 disposée dans une cuvette en acier 10, par exemple. On utilise classiquement, à cet effet, une perle de verre. Chaque broche 11 présente une partie dépassant à l'extérieur du boîtier et qui se termine par une ogive, et une partie dépassant à l'intérieur du boîtier destinée à la soudure d'un fil de connexion du ou des circuits dont doit être muni le boîtier. Après montage d'un ou plusieurs substrats dans la cavité 12 sur le boîtier, un couvercle 15 est soudé ou brasé sur le cadre 17 de manière à rendre le boîtier hermétique.

Ainsi, le dessus de cette cavité 12 permet par adjonction d'un cadre métallique 17 de réaliser une fermeture par soudure ou brasure et d'avoir aussi un boîtier encapsulé étanche à l'hélium, par exemple.

Sous ce boîtier d'encapsulation formant un ensemble monobloc, un ou plusieurs circuits de réfrigération 16 peuvent être intégrés à l'ensemble. Le circuit 16 de circulation de fluide caloporteur est réalisé dans la masse par perçage profond d'alésage. Des ajours pratiqués en extrémité des cloisons séparant les alésages permettent d'établir la libre circulation du ou des fluides, l'étanchéité est réalisée par deux parties métalliques 7 brasées de chaque côté 8 de ces perçages.

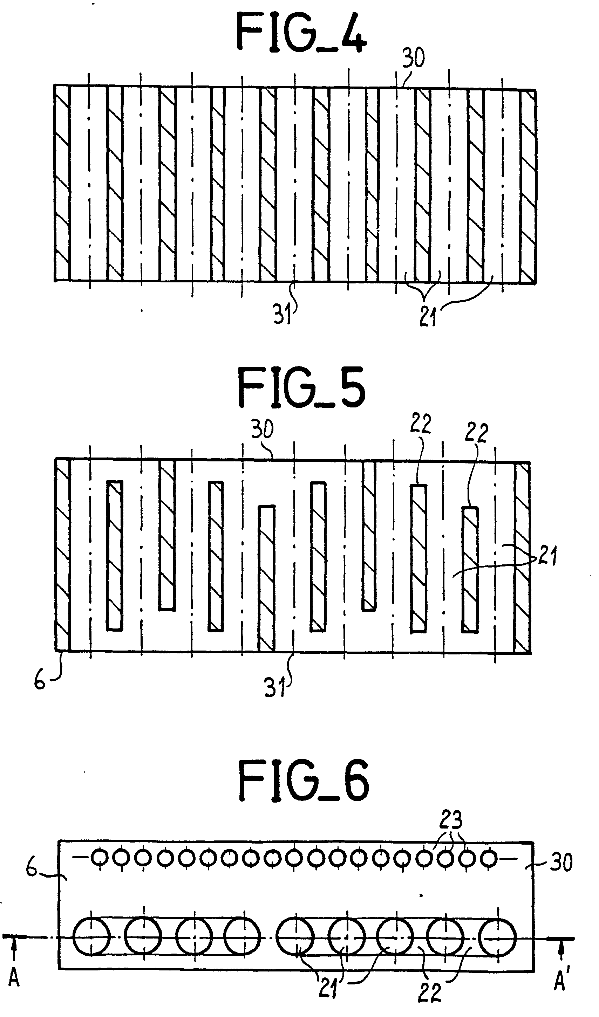

La figure 3 représente l'armature métallique 6 seule munie dans sa partie supérieure d'une cavité 12 dont le fond est destiné à la fixation des circuits électriques et dont les parois latérales comportent des orifices 23 qui permettront la mise en place des broches 11 de connexion. Cette armature 6 est munie dans sa partie inférieure de moyens de refroidissement 16 par circulation d'au moins un fluide caloporteur qui comprend un ensemble monobloc entre les parois latérales 30 et 31 duquel ont été percés des alésages 21 de directions parallèles et régulièrement espacés comme représenté à la figure 4 qui est une vue en coupe selon AA'.

Des ajours 22 ont été percés ensuite aux extrémités des cloisons séparant certains de ces alésages 21, comme représenté à la figure 5 qui est, elle aussi, une vue en coupe selon AA' de manière à obtenir le réseau de circulation désiré de fluide caloporteur.

La figure 6 représente une vue du côté 31 de cette armature métallique, une fois les alésages 21 et les ajours 22 percés.

Les deux éléments métalliques 7, représentés à la figure 2, sont disposés sur les parois latérales 30 et 31 de cette armature métallique 6 de manière à obturer les extrémités de ces alésages 21 et de ces ajours 22.

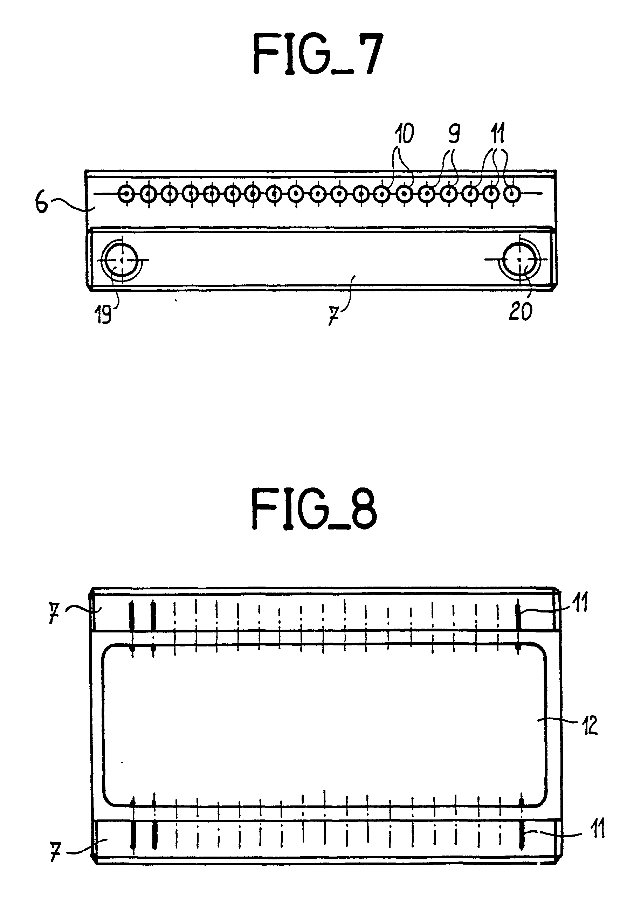

Ces moyens de refroidissement 16 comportent au moins deux orifices 19, 20 de manière à permetre l'introduction et l'évacuation de fluide caloporteur. Ces orifices 19, 20 peuvent être percés dans l'un de ces deux éléments métalliques 7, comme représenté à la figure 7, mais ils peuvent, tout aussi bien, être percés dans le fond de l'armature métallique 6.

Les alimentations et évacuations des fluides peuvent alors être réalisées avec des raccords, brasés ou collés avec des colles aléoétanches permettant une interconnexion rapide et facile avec un échangeur thermique ou une source de fluide réfrigérant.

Les figures 7 et 8 représentent une vue de côté et une vue de dessus du boîtier selon l'invention tel que représenté à la figure 1.

Ainsi, le boîtier selon l'invention réalise une fonction de conduction entre les circuits électriques et les moyens de refroidissement au travers de l'épaisseur de métal de l'armature metallique située entre le fond 13 de la cavité 6 et les alésages 21.

Il réalise aussi une fonction d'échange par son utilisation d'au moins un fluide caloporteur.

Il intègre donc la partie conductrice de la chaleur et la partie échange thermique.

Le boîtier de l'invention possède des moyens de refroidissement qui sont modulaires. En effet, il permet de réaliser, à volonté, des circuits série, parallèle de circulation de fluide de manière à effectuer un refroidissement au plus près des pièces chaudes sans échauffement des pièces restées froides. En pouvant ainsi faire varier la surface d'échange, qui est fonction du diamètre des alésages et ajours percés, à débit constant on peut ainsi faire varier la résistance thermique de l'ensemble des moyens de refroidissement.

Il est aussi possible avec un tel boîtier de réguler le fluide caloporteur à une température déterminée. On peut d'ailleurs considérer plusieurs circuits de refroidissement indépendants ou qui interfèrent entre eux.

Le boîtier de l'invention permet, en outre, d'encapsuler des systèmes de grandes dimensions par exemple de 150 mm x 150 mm.

Les matériaux utilisés pour l'armature métallique 6 et les deux éléments métalliques 7 sont généralement des alliages a base de cuivre, ou d'aluminium choisis pour leur bonne conductibilité thermique.

Ainsi, les alliages à base de cuivre peuvent être des cuprochromes ou des alliages cuivre-beryllium-cobalt par exemple qui permettent d'obtenir des matériaux durs, résistants à la corosion et possédant un coefficient de dissipation thermique élevé. Les brasures peuvent être alors des brasures haute température argent-cuivre eutectique qui fondent à 780° C environ.

Les alliages à base d'aluminium peuvent être des alliages aluminium-silicium. Les brasures peuvent être, alors, des brasures plomb-argent eutectique qui fondent à 315° C environ.

Le cadre 17 et le couvercle 15 peuvent être réalisés en fer-nickel-cobalt.

Des revêtements de protection peuvent être réalisés sur l'ensemble du boîtier par exemple de nickel, d'étain, ou d'or.

Les fluides caloporteurs peuvent être, par exemple, l'eau, l'huile.

Les circuits électriques peuvent être des composants disposés sur un circuit imprimé qui est collé au fond 13 de la cavité 12. Ils peuvent être, aussi, des circuits hyperfréquences qui sont fixés mecaniquement au fond 13 de la cavité 12.

## Revendications

1. Boîtier métallique d'encapsulation de circuits électriques à dissipation thermique élevée, comportant une armature (6) métallique monobloc limitée par des faces latérales, ladite armature comprenant une partie supérieure comportant une cavité (12) dont le fond (13) est destiné à la fixation de ces circuits électriques, et dont les parois latérales (14) supportent des connexions (11) par l'intermédiaire de traversées isolantes (9), un couvercle (15) étant disposé à la surface de cette cavité (12) de manière à rendre celle-ci hermétique, ladite armature comprenant en outre une partie inférieure contenant des moyens de refroidissement (16), pour circulation d'au moins un fluide caloporteur, les moyens de refroidissement étant constitués par un réseau modulaire de circulation du fluide caloporteur de manière à effectuer un refroidissement au plus près des pièces chaudes sans échauffement des pièces restées froides, ledit réseau étant obtenu au moyen d'alésages (21) percés entre deux faces latérales parallèles, régulièrement espacés, séparés les uns des autres par des cloisons parallèles, deux alésages voisins communiquant entre eux à l'aide d'ajours percés dans une des ou les deux extrémités de la cloison commune, deux éléments (7) métalliques étant disposés sur les faces latérales de cette armature monobloc de manière à obturer les extrémités de ces alésages (21) et les ajours (22), ces moyens de refroidissement (16) comportant au moins deux orifices (19, 20) de manière à permettre l'entrée et la sortie du fluide caloporteur.

2. Boîtier selon la revendication 1, caractérisé en ce que les deux éléments métalliques (7) sont brasés de part et d'autre de la partie inférieure de l'armature métallique (6).

3. Boîtier selon la revendication 1, caractérisé en ce qu'il comprend un cadre métallique (17) disposé entre l'armature métallique (6) et le couvercle (15) de manière à souder le couvercle (15) à cette armature métallique (6).

4. Boîtier selon la revendication 1, caractérisé en ce que les traversées isolantes (9) sont des perles de verre.

5. Boîtier selon la revendication 4, caractérisé en ce que ces perles de verre (9) sont disposées dans des cuvettes (10) en acier.

6. Boîtier selon la revendication 1, caractérisé en ce que les connexions (11) sont des broches implantées par brasure.

7. Boîtier selon la revendication 1, caractérisé en ce que des raccords sont disposés dans les orifices (19, 20) pour permettre l'alimentation et l'évacuation de fluide caloporteur.

8. Boîtier selon la revendication 7, caractérisé en ce que ces raccords sont fixés par brasure.

9. Boîtier selon la revendication 7, caractérisé en ce que ces raccords sont fixés par collage à l'aide d'une colle aléoétanche.

10. Boîtier selon la revendication 1, caractérisé en ce que l'armature métallique (6) et les deux éléments métalliques (7) sont réalisés en alliages à base de cuivre.

11. Boîtier selon la revendication 10, caractérisé en ce que ces alliages à base de cuivre sont des cuprochromes.

12. Boîtier selon la revendication 10, caractérisé en ce que ces alliages à base de cuivre sont des alliages cuivre-beryllium-cobalt.

13. Boîtier selon la revendication 10, caractérisé en ce que le matériau de brasure est de l'argent-cuivre eutectique.

14. Boîtier selon la revendication 1, caractérisé en ce que l'armature métallique (6) et les deux éléments métalliques (7) sont réalisés en alliages à base d'aluminium.

15. Boîtier selon la revendication 14, caractérisé en ce que ces alliages à base d'aluminium sont des alliages aluminium-silicium.

16. Boîtier sleon la revendication 14, caractérisé en ce que le matériau de brasure est du plomb-argent eutectique.

17. Boîtier selon la revendication 1, caractérisé en ce que le cadre (17) et le couvercle (15) sont en ferro-nickel-cobalt.

18. Boîtier selon la revendication 1, caractérisé en ce qu'il reçoit un revêtement en un matériau choisi parmi les matériaux suivants nickel, étain, or.

19. Boîtier selon la revendication 1, caractérisé en ce qu'un fluide caloporteur est de l'eau.

20. Boîtier selon la revendication 1, caractérisé en ce qu'un fluide caloporteur est de l'huile.

21. Boîtier selon la revendication 1, caractérisé en ce que les circuits électriques sont fixés par soudure au fond (13) de la cavité (12).

22. Boîtier selon la revendication 1, caractérisé en ce que les circuits électriques sont fixés par brasure au fond (13) de la cavité (12).

23. Boîtier selon la revendication 1, caractérisé en ce que les circuits électriques sont disposées sur un circuit imprimé collé sur le fond (13) de la cavité (12).

24. Boîtier selon la revendication 1, caractérisé en ce que les circuits électriques sont des circuits hyperfréquences fixés mécaniquement sur le fond (13) de la cavité (12).


**Patentansprüche**

1. Metallisches Verkapselungsgehäuse für elektrische Schaltungen mit hoher Wärmezerstreuung, welches eine metallische Armierung (6) aus einem Stück aufweist, die durch seitliche Flächen begrenzt ist, wobei die Armierung einen oberen Bereich aufweist, der einen Hohlraum (12) aufweist, dessen Boden (13) für die Festlegung der elektrischen Schaltkreise bestimmt ist, und dessen Seitenwände (14) Verbindungen (11) mittels isolierender Überquerungen (9) tragen, wobei ein Deckel (15) an der Oberfläche des Hohlraums (12) derart angeordnet ist, daß er diesen hermetisch abdichtet, wobei die Armierung weiterhin einen unteren Bereich aufweist, der Kühlmittel (16) für die Zirkulation wenigstens eines wärmetransportierenden Fluides aufweist, wobei die Kühlmittel von einem modularen Raumraster der Zirkulation des wärmetransportierenden Fluides derart gebildet sind, um eine Kühlung am nächsten der heißen Teile ohne Aufheizen der kühl gebliebenen Teile zu bewirken, wobei das Raster mittels Bohrungen (21) erhalten wird, die zwischen zwei parallele Seitenflächen eingebracht, in regelmäßigen Abständen voneinander angeordnet und durch parallele Trennwände voneinander getrennt sind, wobei zwei benachbarte Bohrungen miteinander mit Hilfe von Durchbrüchen in Verbindung stehen, die in dem einen oder in beiden Enden der gemeinsamen Trennwand eingebracht sind, wobei zwei metallische Elemente (7) an den Seitenflächen dieser einstückigen Armierung derart angeordnet sind, um die Enden dieser Bohrungen (21) und die Durchbrüche (22) zu verschließen, wobei die Kühlmittel (16) wenigstens zwei Öffnungen (19, 20) derart aufweisen, daß sie den Eintritt und den Austritt des wärmetransportierenden Fluids ermöglichen.

2. Gehäuse nach Anspruch 1, dadurch gekennzeichnet, daß die beiden metallischen Elemente (7) an beiden Seiten des unteren Bereiches der metallischen Armierung (6) angelötet sind.

3. Gehäuse nach Anspruch 1, dadurch gekennzeichnet, daß es einen metallischen Rahmen (17) aufweist, der zwischen der metallischen Armierung (6) und dem Deckel (15) derart angeordnet ist, um den Deckel (15) mit der metallischen Armierung (6) zu verschweißen.

4. Gehäuse nach Anspruch 1, dadurch gekennzeichnet, daß die isolierenden Überquerungen (9) Glasperlen sind.

5. Gehäuse nach Anspruch 4, dadurch gekennzeichnet, daß die Glasperlen (9) in Schalen (10) aus Stahl angeordnet sind.

6. Gehäuse nach Anspruch 1, dadurch gekennzeichnet, daß die Verbindungen (11) Kontaktlamellen sind, die durch Löten implantiert sind.

7. Gehäuse nach Anspruch 1, dadurch gekennzeichnet, daß die Verbindungsstücke in den Öffnungen (19, 20) angeordnet sind, um das Zuführen und Evakuieren des wärmetransportierenden Fluides zu ermöglichen.

8. Gehäuse nach Anspruch 7, dadurch gekennzeichnet, daß die Verbindungsstücke durch Löten festgelegt sind.

9. Gehäuse nach Anspruch 7, dadurch gekennzeichnet, daß die Verbindungsstücke durch Kleben mit Hilfe eines aleodichten (aléoétanche) Klebers fixiert sind.

10. Gehäuse nach Anspruch 1, dadurch gekennzeichnet, daß die metallische Armierung (6) und die beiden metallischen Elemente (7) durch Legierungen auf der Basis von Kupfer verwirklicht sind.

11. Gehäuse nach Anspruch 10, dadurch gekennzeichnet, daß die Legierung auf der Basis von Kupfer Kupfer-Chrom-Legierungen sind.

12. Gehäuse nach Anspruch 10, dadurch gekennzeichnet, daß die Legierungen auf der Basis von Kupfer Kupfer-Beryllium-Kobalt-Legierungen sind.

13. Gehäuse nach Anspruch 10, dadurch gekennzeichnet, daß das Lötmaterial Silbereutektisches Kupfer ist.

14. Gehäuse nach Anspruch 1, dadurch gekennzeichnet, daß die metallische Armierung (6) und die beiden metallischen Elemente (7) aus Legierungen auf der Basis von Aluminium verwirklicht sind.

15. Gehäuse nach Anspruch 14, dadurch gekennzeichnet, daß die Legierungen auf der Basis von Aluminium-Silizium-Legierungen sind.

16. Gehäuse nach Anspruch 14, dadurch gekennzeichnet, daß das Lötmaterial Bleieutektisches Silber ist.

17. Gehäuse nach Anspruch 1, dadurch gekennzeichnet, daß der Rahmen (17) und der Deckel (15) aus Eisen-Nickel-Kobalt sind.

18. Gehäuse nach Anspruch 1, dadurch gekennzeichnet, daß es einen Überzug aus einem Material erhält, das aus den folgenden Stoffen gewählt ist: Nickel, Zinn, Gold.

19. Gehäuse nach Anspruch 1, dadurch gekennzeichnet, daß ein wärmetransportierendes Fluid Wasser ist.

20. Gehäuse nach Anspruch 1, dadurch gekennzeichnet, daß ein wärmetransportierendes Fluid Öl ist.

21. Gehäuse nach Anspruch 1, dadurch gekennzeichnet, daß die elektrischen Schaltkreise durch Schweißen am Boden (13) des Hohlraums (12) befestigt sind.

22. Gehäuse nach Anspruch 1, dadurch gekennzeichnet, daß die elektrischen Schaltkreise durch Löten am Boden (13) des Hohlraums (12) befestigt sind.

23. Gehäuse nach Anspruch 1, dadurch gekennzeichnet, daß die elektrischen Schaltkreis auf einem gedruckten Schaltkreis angeordnet sind, der auf den Boden (13) des Hohlraums (12) aufgeklebt ist.

24. Gehäuse nach Anspruch 1, dadurch gekennzeichnet, daß die elektrischen Schaltkreise ultrahochfrequente Schaltkreise sind, die mechanisch an dem Boden (13) des Hohlraums (12) befestigt sind.

**Claims**

1. A metallic casing for enclosing electric circuits allowing high heat dissipation comprising a monobloc metallic framework (6) limited by lateral faces, said framework having an upper portion, comprising a cavity (12), the base (13) of which is intended to fix these electric circuits and the lateral walls (14) of which bear connections (11) by means of bushings (9), a cover (15) being arranged on the surface of this cavity (12) so that the cavity is hermetically sealed, said framework also having a lower portion containing cooling means (16), for circulation of at least one heat-carrying fluid, the cooling means being constituted by a modular network for the circulation of the heat-carrying fluid so as to carry out cooling as close as possible to the hot parts without heating the parts which have remained cool, said network being obtained by means of bores (21) made between two evenly spaced, parallel lateral faces which are separated from one another by parallel partitions, two adjacent bores intercommunicating by means of openings perforated in one or both ends of the common partition, two metallic elements (7) being arranged on the lateral faces of this monobloc framework so as to block the ends of these bores (21) and the openings (22), these cooling means (16) comprising at least two orifices (19, 20) so as to allow the admission and the discharge of the heat-carrying fluid.

2. A casing according to claim 1, characterised in that the two metallic elements (7) are soldered on either side of the lower portion of the metallic framework (6).

3. A casing according to claim 1, characterised in that it comprises a metallic frame (17) arranged between the metallic framework (6) and the cover (15) so as to weld the cover (15) to this metallic framework (6).

4. A casing according to claim 1, characterised in that the bushings (9) are glass beads.

5. A casing according to claim 4, characterised in that these glass beads (9) are arranged in steel dishes (10).

6. A casing according to claim 1, characterised in that the connections (11) are pins installed by soldering.

7. A casing according to claim 1, characterised in that connecting pieces are arranged in the orifices (19, 20) to allow the supply and discharge of the heat-carrying fluid.

8. A casing according to claim 7, characterised in that these connecting pieces are fixed by soldering.

9. A casing according to claim 7, characterised in that these connecting pieces are fixed by adhesion using a water- and oil-tight adhesive.

10. A casing according to claim 1, characterised in that the metallic framework (6) and the two metallic elements (7) are produced from copper-based alloys.

11. A casing according to claim 10, characterised in that these cooper-based alloys are cuprochromiums.

12. A casing according to claim 10, characterised in that these cooper-based alloys are cooper-beryllium-cobalt alloys.

13. A casing according to claim 10, characterised in that the soldering material is eutectic silver-copper.

14. A casing according to claim 1, characterised in that the metallic framework (6) and the two metallic elements (7) are produced from aluminium-based alloys.

15. A casing according to claim 14, characterised in that these aluminium-based alloys are aluminium-silicon alloys.

16. A casing according to claim 14, characterised in that the soldering material is eutectic lead-silver.

17. A casing according to claim 1, characterised in that the frame (17) and the cover (15) are made of ferronickel -cobalt.

18. A casing according to claim 1, characterised in that it receives a coating made of a material selected from the following materials: nickel, tin, gold.

19. A casing according to claim 1, characterised in that water is a heat-carrying fluid.

20. A casing according to claim 1, characterised in that oil is a heat-carrying fluid.

21. A casing according to claim 1, characterised in that the electric circuits are fixed by welding to the base (13) of the cavity (12).

22. A casing according to claim 1, characterised in that the electric circuits are fixed by soldering to the base of the cavity (12).

23. A casing according to claim 1, characterised in that the electric circuits are arranged on a printed circuit stuck on the base (13) of the cavity (12).

24. A casing according to claim 1, characterised in that the electric circuits are ultra-high frequency circuits mechanically fixed on the base (13) of the cavity (12).

# FIG_1

# FIG_2

# FIG_3

1

# FIG_4

# FIG_5

# FIG_6

# FIG_7

# FIG_8